# EUROPEAN PATENT APPLICATION

(11) **EP 4 737 610 A1**
(43) Date of publication of application: **06.05.2026**
(21) Application number: 25182398.5
(22) Date of filing: 12.06.2025
(51) Int. Cl.: C23C 16/26, C23C 16/509

(54) **A METHOD OF PLASMA-ENHANCED CHEMICAL VAPOR DEPOSITION**

(30) Priority: 31.10.2024 GB 202416033
(71) Applicant: SPTS Technologies Limited, Newport Gwent NP18 2TA (GB)
(72) Inventor: CROOK, Katherine, Newport (GB); ROYLE, William, Newport (GB); RUCINSKA, Emilia, Newport (GB); PARFITT, Mollie, Newport (GB)
(74) Representative: Wynne-Jones IP Limited

(57) **Abstract**

There is provided a method of plasma-enhanced chemical vapor deposition comprising the steps of: supporting a wafer within a reactor chamber on a wafer support; generating a plasma from acetylene, hydrogen and argon gases using a high frequency RF power supply; and depositing an amorphous hydrogenated carbon film on the wafer; wherein during the deposition the reactor chamber pressure is within the range 1-6 Torr; and wherein during the deposition the wafer support temperature is between 200-350 degrees Celsius; such that the deposited amorphous hydrogenated carbon film provides a dielectric layer on the wafer exhibiting low leakage currents of less than 1.0E-07 A/cm² at an operating voltage of 2 MV/cm and a high breakdown voltage of more than 6 MV/cm.

## Description

### Introduction

This invention relates to a method of plasma-enhanced chemical vapor deposition (PECVD), in particular, a method of depositing an amorphous hydrogenated carbon thin film on a wafer that has excellent electrical isolation properties. This invention also relates to a PECVD apparatus configured to undertake such a method.

### Background

Plasma-enhanced chemical vapor deposition (PECVD) techniques can be used to deposit carbon thin films for various purposes where carbon coatings are required. The films can include for example diamond-like carbon films, 2D carbon layer films and polymer films. It will be appreciated that a "thin film" is a film having a thickness of no more than a few micrometres. The films tend to be disordered or amorphous over most practical process parameters. They are commonly defined as amorphous carbon (a-C) or amorphous hydrogenated carbon (a-C:H) films.

Dense amorphous hydrogenated carbon films (i.e. with a density above 1.8 g/cc) can be used for example to provide a hard diamond-like carbon (DLC) protective layer on a substrate for advanced patterning applications, providing improved etch selectivity over conventional SiO₂ or SiN masks.

It is preferable for reasons of efficiency and ease of manufacture, to deposit films at low temperatures, below 350 degrees Celsius. It will be appreciated that the temperature being referred to is the wafer temperature/ wafer support temperature.

It would be advantageous to develop suitable methods of depositing an amorphous hydrogenated carbon film to be used as a dielectric film in an interconnect scheme. This would provide an alternative to conventional films such as SiO₂, SiN, SiC and SiCN films. The film should be deposited at a low temperature, and at an acceptable deposition rate, for economic reasons.

### Summary

In a first aspect of the invention there is provided a method of plasma-enhanced chemical vapor deposition. The method comprises the steps of: supporting a wafer within a reactor chamber on a wafer support; generating a plasma from acetylene, hydrogen and argon gases using a high frequency RF power supply; and depositing an amorphous hydrogenated carbon film on the wafer. During the deposition the reactor chamber pressure is within the range 1-6 Torr and the wafer support temperature is between 200-350 degrees Celsius such that the deposited amorphous hydrogenated carbon film provides a dielectric layer on the wafer exhibiting low leakage currents of less than 1.0E-07 A/cm² at an operating voltage of 2 MV/cm and a high breakdown voltage of more than 6 MV/cm.

The inventors have recognised that the electrical isolation properties of the deposited film must be adequate for use as a dielectric film in an interconnect scheme. As such a PECVD process has been devised using acetylene, hydrogen and argon gases to deposit, at a sufficiently fast deposition rate, an amorphous hydrogenated carbon film displaying low leakage currents and a high breakdown voltage. This has been achieved with a high frequency power supply, a reactor chamber pressure within the range 1-6 Torr and wafer temperature between 200-350 degrees Celsius. A lower platen/ wafer support temperature (<350 degrees Celsius) has been found to enable a fast deposition rate, however beneath a certain temperature, the electrical performance of the film has been found to deteriorate. A suitable temperature for the platen to enable an acceptable deposition rate and still provide suitable electrical properties has been found to be 200-350 degrees Celsius.

Without being bound by any conjecture it is proposed that amorphous hydrogenated carbon film deposited below 200 degrees Celsius and above 350 degrees Celsius using the C₂H₂/Ar/H₂ chemistry and a high frequency RF plasma result in structural changes in the film which degrade the dielectric properties of the film. At lower temperatures higher density films are deposited which contain excess sp2 bonding (determined from FTIR sp3/sp2 ratios) which result in degraded dielectric properties, while at high temperatures insufficient hydrogen can be incorporated into the film to adequately passivate dangling bonds in the low density a-C matrix, once again producing degraded dielectric properties when compared to the present films.

Optionally, the wafer temperature is in the range 225-325 degrees Celsius, more preferably in the range 250-300 degrees Celsius. The density of the film has been found to depend on temperature, and furthermore the density of the film has been found to impact the electrical performance of the film. A narrow range of densities corresponding to temperatures between 225-325, more optimally 250-300 has been found to provide optimal electrical properties.

The plasma is generated using a high frequency RF supply i.e. a power supply in excess of 1 MHz, typically greater than 2MHz. Optionally, the plasma is generated using a RF power supply at 13.56 MHz. It has been found that varying the power results in films having different electrical characteristics. Using a high frequency source (in excess of 1 MHz) has been found to result in superior electrical characteristics compared to films deposited using a lower frequency source (i.e. below 1 MHz).

Optionally, the plasma is generated using a RF power supply providing a power between 500-1500 W. A low power (i.e. less than 1500 W) and high frequency RF plasma advantageously results in a lower density film because it avoids excessive ion bombardment which creates a denser film.

Optionally, the reactor chamber pressure is within the range 1.5-5 Torr. Varying the pressure along with the other process conditions was found to impact the electrical performance of the deposited film, with a pressure in the range 1.5-5 Torr providing optimal characteristics.

Optionally, the method is undertaken in a capacitively coupled reactor.

Optionally, the acetylene gas is supplied to the reactor chamber at a flow rate in the range 100-600 sccm, more preferably in the range 200-550 sccm.

Optionally, the hydrogen gas is supplied to the reactor chamber at a flow rate in the range 100-600 sccm, more preferably in the range 250-550 sccm.

Optionally, the argon gas is supplied to the reactor chamber at a flow rate in the range 200-1000 sccm, more preferably in the range 300-900 sccm.

Optionally, the wafer is a 300 mm silicon wafer. The wafer may have a standard thickness for example ~775 µm.

Optionally, the film deposited has a thickness between 150-1000 nm.

Ideally the films deposited are low density films. The deposited amorphous hydrogenated carbon film may have a density of 1.6-1.8 g/cc.

In a second aspect of the invention there is provided a plasma-enhanced chemical vapor deposition system configured to undertake the method of the first aspect, the system comprising: a reactor chamber; a gas inlet arranged to supply acetylene, hydrogen and argon gases to the reactor chamber; a wafer support configured to support a wafer within the reactor chamber; and an RF power supply coupled to the reactor chamber.

The wafer support may be grounded and arranged to be resistively heated to thereby heat the wafer.

The system may further comprise a cooling mechanism associated with the wafer support and configured to cool the wafer.

The system may further comprise one or more flow control units configured to adjust the flow of the gases into and/or out of the reactor chamber.

### Brief Description of the Drawings

An embodiment of the invention will now be described by way of example only with reference to the following drawings:
Figure 1 is a schematic cross-sectional view of a PECVD apparatus according to the example embodiment;
Figure 2 is a schematic representation of a method of PECVD according to the example embodiment;
Figure 3 shows the electrical performance of films obtained in experiments performed according to the method of Figure 2;
Figure 4 shows the effects of varying temperature on the film electrical properties;
Figure 5 shows the FTIR spectra of films as a function of H₂ flow;
Figure 6 shows the FTIR spectra of films as a function of temperature;
Figure 7 shows the effects of varying temperature on the film density;
Figure 8 shows how breakdown voltages are impacted by film density.

### Detailed Description

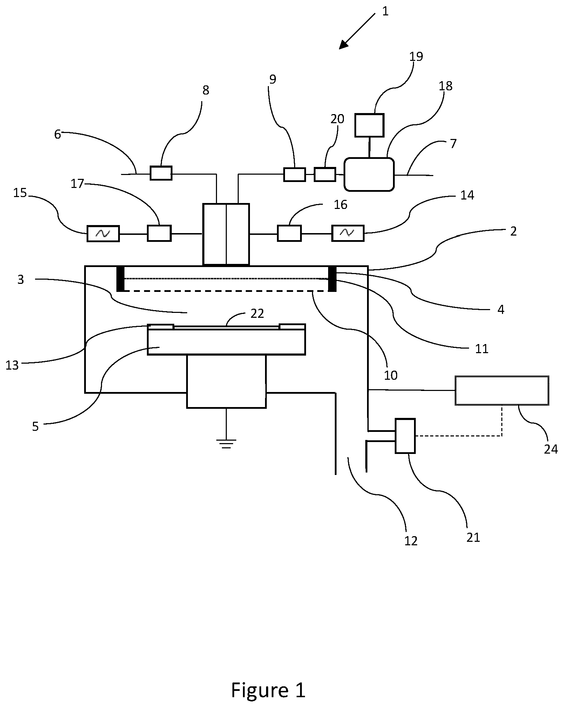

According to the example embodiment of the invention, Figure 1 shows a schematic representation of a PECVD system 1 in accordance with an embodiment of the invention. Within a metallic chamber 2, a process region 3 in which a plasma is created, is defined between a substrate support 5 and a gas inlet system comprising an aluminium showerhead 4. During use, gases pass into a rear side of the showerhead 4 and are projected into the process region 3 through a series of small holes 10 in the showerhead 4 via an internal gas distribution plate 11. The substrate support 5 is grounded and the showerhead 4 is powered by a plasma generating means comprising two different RF supplies 14, 15, each of which operate at different RF frequencies, and their associated matching units 16, 17. The grounded substrate support 5 is resistively heated during use to heat the wafer. A cooling mechanism (not shown) enables control of the wafer temperature.

There is a dielectric break (not shown) between the aluminium showerhead 4 and the metallic chamber 2. In a different embodiment, alternative plasma generating means may be used, for example with an arrangement wherein the substrate support 5 is RF driven and the gas distribution plate 11 is grounded. During use, process and cleaning gases enter the gas inlet system through pipes 6, 7 comprising isolation valves 8, 9. Multiple gas sources are linked to pipes 6, 7 by means of a manifold (not shown) with isolation valves, mass flow controllers and related components. The grounded chamber 2 is evacuated though an exhaust 12 by means of a pump (not shown).

A typical process cycle commences by loading a substrate 22 into the evacuated chamber 2 and placing the substrate onto the substrate support 5. The substrate is placed within an annular uniformity ring 13 situated on the substrate support upper surface. A process gas or gas mixture passes through the left side gas pipe 6 with the corresponding valve 8 open and enters the chamber 2 through the showerhead 4. When the desired gas flow and pressure are achieved a system controller 24 associated with the chamber 2 signals for RF power to be delivered by either or both of the RF supplies 14, 15 to the showerhead 4, thereby initiating a plasma within the chamber 2 between the showerhead 4 and the substrate support 5. Pressure is controlled by controlling the flow of gases into and out of the chamber 2 for example by controlling the pump speed through the exhaust and/or using mass flow controllers to control flow into the chamber, as will be understood in the art.

The high frequency RF supply 14 operates at 10-20 MHz while the low frequency RF supply 15 operates at 375 kHz - 2 MHz. Matching units 16 and 17 enable efficient coupling of the RF power into the showerhead 4.

When the desired thickness of deposition has been achieved (no more than a few micrometers for a thin film), the controller 24 emits a OFF signal and the power is switched off and the process gas flow is stopped. The controller 24 is coupled to a plurality of sensors within the chamber 2. The chamber 2 is evacuated as the process gases pass through the exhaust 12, and then the substrate 22 is removed from the chamber 2.

A typical remote chamber cleaning process commences by passing the reactive cleaning gases and any inert gases through the right side gas pipe 7, remote plasma source 18, associated connector 20 and valve 9 (in an open configuration), through the showerhead 4 and into the chamber 2. Power is then delivered to the remote source 18 from connected power supply 19 to produce a high density plasma in the remote source 18, which in turn provides a source of radicals to clean the chamber 2 through the connector 20. The connector 20 can be provided at any location downstream of the remote source 18 before the showerhead 4. The connector 20 can be electrically insulating, such as a dielectric connector, and can be provided with a plurality of gas conducting bores having a diameter of less than 10 mm, to ensure that the energetic ions in the plasma generated in the remote plasma source 18 does not reach the chamber 2, but that radicals do reach the chamber 2.

To determine the chamber clean end point, a monitoring device 21, in the present example in the form of an infra red gas analyzer, is situated in the exhaust 12. By monitoring characteristics such as the IR signature of the gases and volatile components leaving the chamber 2 through the exhaust 12, it is possible to map the intensity of the emissions as a function of time and in turn determine when the chamber 2 has been fully cleaned. The monitoring device 21 is in communication with the controller 24.

The controller 24 is configured to control each component of the system 1 in both process and cleaning modes of operation.

In the example embodiment, the substrate 22 comprises a 300 mm circular silicon wafer (in a different embodiment it may comprise another suitable substrate). The wafer has a standard thickness of ~775 µm.

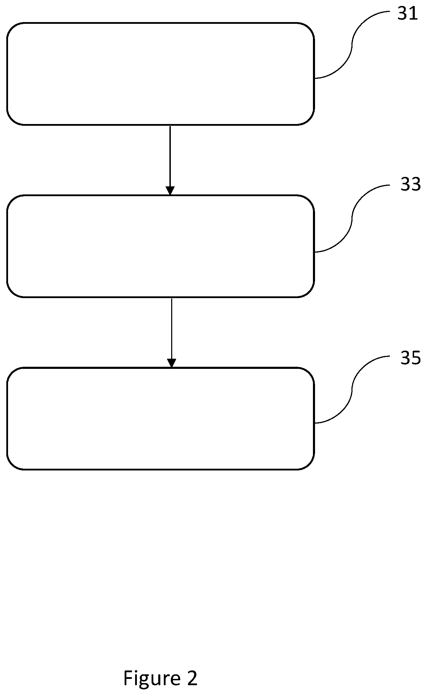

The method of plasma enhanced chemical vapor deposition comprises the general steps of (Figure 2): supporting 31 the wafer within the reactor chamber; generating 33 a plasma from acetylene, hydrogen and argon gases supplied to the reactor chamber using a high frequency RF power supply; and depositing 35 a film on the wafer. The film is an amorphous hydrogenated carbon film. During the deposition the reactor chamber pressure is within the range 1-6 Torr and the wafer temperature is in the range 200-350 degrees Celsius. Performed as such, the deposition results in a deposited amorphous hydrogenated carbon film which can function suitably as a dielectric layer.

In the example embodiment of the invention, the step of generating 33 a plasma from acetylene, hydrogen and argon gases supplied to the reactor chamber comprises feeding acetylene gas to the reactor chamber at a flow rate of 100-600 sccm, feeding hydrogen gas to the reactor chamber at a flow rate of 200-800 sccm, and feeding argon gas to the reactor chamber at a flow rate of 300-1000 sccm. The gas pressure is maintained at ~1.5-5 Torr.

A high frequency RF power (in the example embodiment at 13.56 MHz) is applied across parallel plates within the reactor chamber to generate the plasma from the process gases. A first plate (i.e. electrode) is provided by the wafer support 5, which is grounded. A second plate (i.e. electrode) is provided by the showerhead 10, which is powered. Although the system 1 is capable of supplying mixed frequencies, in the example embodiment, the system is utilised at a single frequency only. A relatively low RF power (beneath 1500 W) is supplied by a high frequency RF power supply 15 (in the example embodiment at 13.56MHz).

The step of depositing 35 a film on an upper surface of the wafer 22 comprises depositing by plasma deposition a film of thickness between 50-1500 nm on the wafer. The wafer support 5 is resistively heated to a temperature below 350 degrees Celsius, preferably between 150-350 degrees Celsius, thereby heating the wafer to the same temperature. The film is preferably deposited at a deposition rate between 100-300 nm/minute.

Experimental work was performed using an SPTS Delta^{™} fxP PECVD system i.e. a capacitively coupled mixed frequency parallel plate single wafer PECVD system. It will be appreciated that other PECVD systems would be suitable. The experiments were performed using 300 mm bare silicon wafers, having a standard thickness of ~775 µm. Amorphous hydrogenated carbon films, within the thickness range 150 nm to 1000 nm, were deposited on the silicon wafers, and the film properties were measured. The amorphous hydrogenated carbon films were deposited at temperatures between 200-350 degrees Celsius using acetylene, argon and hydrogen process gases at ~1.5-5 Torr pressure. The gases were fed at flow rates in the range 200-1000 sccm. Deposition rates varied from 120-240 nm/minute. High frequency, low source power was supplied at 200-1500 W.

In the experiments, the amorphous hydrogenated carbon films deposited as described were found, in contrast to a reference hard mask amorphous hydrogenated carbon film, to have electrical characteristics well-suited for use as dielectric film. The reference hard mask amorphous hydrogenated carbon film was deposited at 300 degrees Celsius using a low frequency RF component at 380 kHz resulting in a high density (~2.8 g/cc) film with a refractive index ~1.95.

Leakage currents and breakdown voltages were determined using a Keithley 4200A Parametric Analyser. It will be appreciated that other analysers would be suitable. Test metal-insulator-metal structures were created by depositing 150nm thick amorphous hydrogenated carbon films on silicon substrates sandwiched between an upper and a lower aluminium electrode. The upper aluminium electrode was evaporated through a metal stencil mask. The sweep voltage was from 0V to 200V in 5V steps at room temperature.

**Table 1: Experimental data - process conditions**

| Parameter | Unit | Range | Preferred Value | |
|---|---|---|---|---|
| | | | Process A | Process C |
| Deposition Temperature | °C | 225-325 | 300 | 300 |
| Pressure | mT | 1500-5000 | 3000 | 3000 |
| HF Power | W | 250-1500 | 500 | 300 |
| H2 | sccm | 250-550 | 550 | 550 |
| C2H2 | sccm | 200-515 | 303 | 303 |
| Ar | sccm | 300-900 | 700 | 560 |

**Table 2: Experimental data - film properties**

| Parameter | Process A | Process C |
|---|---|---|
| Non-uniformity (1σ) | 1.19 | 1.47 |
| Refractive index | 1.6755 | 1.6426 |
| Stress (MPa) | -84 | -20 |
| Leakage current @2MV/cm | 1.14E-06 | 6.94E-08 |
| Breakdown Voltage (MV/cm) | 9 | 8 |
| Dielectric Constant | not measured | 3.07 |

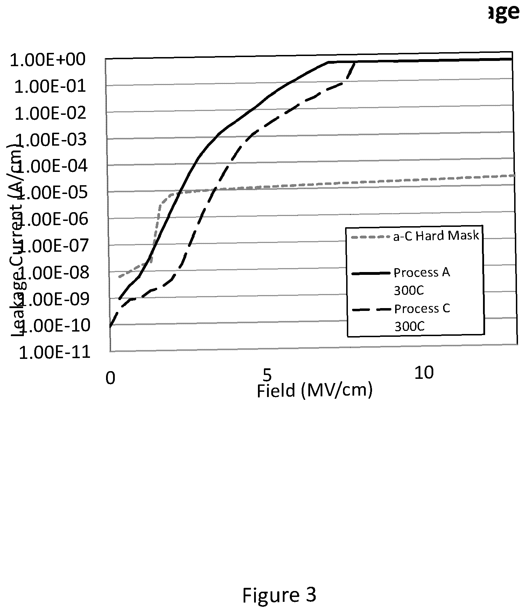

As shown in Figure 3, films deposited as described were found to exhibit low leakage currents (beneath 1.0E-07 A/cm² measured at 2 MV/cm) compared to the reference dense hard mask film and comparatively high breakdown voltages (above 6 MV/cm). In addition the films had low thickness non-uniformity (beneath 2%) and displayed low compressive stress values (beneath 100 MPa). The dielectric constant was relatively low, around 3 in each case. The films were found to be non-crystalline (as determined by X-ray diffraction) and had a refractive index of around 1.6-1.7.

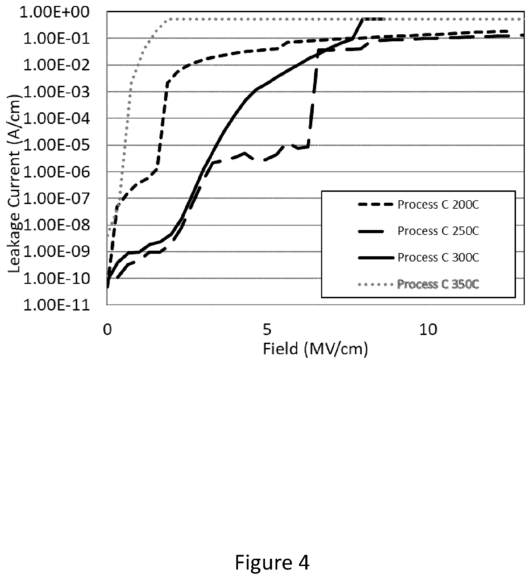

By varying the process conditions the properties of the carbon film can be tuned. In particular, as shown in Figure 4, in experiments based on process C with varying wafer support temperature, it was found that a lower wafer support temperature enabled a faster deposition rate, but with a corresponding deterioration in the electrical performance of the films. For optimal film characteristics a wafer support temperature of ~250-350 degrees Celsius was found to be preferred, with chamber pressure of ~2.5-3.5 Torr, high frequency (10-15 MHz) RF power of 300-500 W, and acetylene, argon and hydrogen process gas flow rates of ~400-600 sccm, ~200-400 sccm and ~500-700 sccm respectively. The experimental data is shown in Table 3.

**Table 3: Experimental data - leakage current as a function of hydrogen flow**

| Temperature (°C) | 200 | 250 | 300 | 350 |
|---|---|---|---|---|
| Dep Rate (nm/min) | 240 | 207 | 169 | 120 |
| Leakage current A/cm² @2MV/cm | 1.27E-03 | 1.76E-09 | 6.94E-08 | 3.97E-01 |
| Breakdown Voltage (MV/cm) | 2 | 6 | 8 | 1 |
| Dielectric Constant | 3.07 | not measured | 3.07 | not measured |

The inclusion of hydrogen as a process gas was found to be especially important. In particular, as shown in Table 4, in experiments based on process C with varying hydrogen flow rate, it was found that too little or too much hydrogen was found to result in unacceptably high leakage currents (wherein the target value for leakage current was less than 1E-07 A/cm² at 2MV/cm).

**Table 4: Experimental data - leakage current as a function of hydrogen flow**

| | Leakage current (A/cm²) @2MV/cm |
|---|---|
| Process C | 4.64E-09 |
| 660 sccm H₂ | 1.14E-01 |
| 275 sccm H₂ | 2.49E-07 |
| No H₂ | 6.49E-03 |

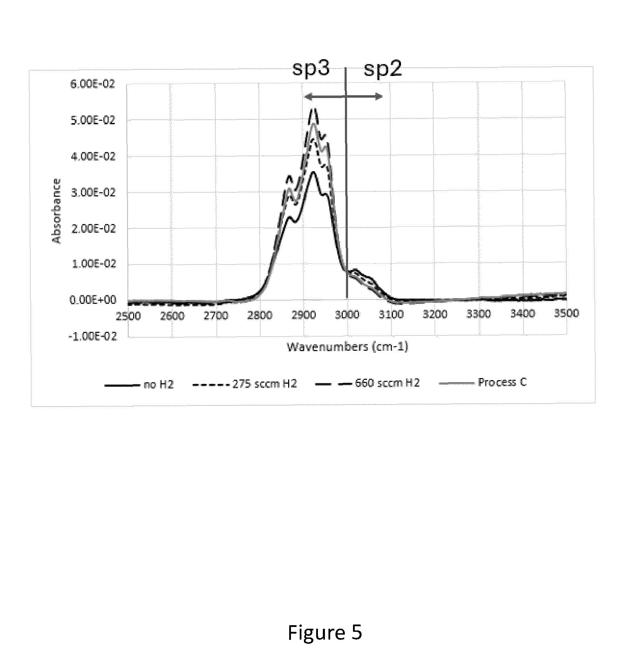

As shown in Figure 5, as H₂ flow increases the sp3 related C-Hx peaks (2800-3000cm-1) all increase while there is an associated reduction in the sp2 peaks above 3000cm-1. This suggests that there is a structural change in the C-Hx stretching bonds when the H₂ partial pressure changes for this set of process conditions. The increased C-Hx peak value corresponds to an increase in hydrogen being incorporated into the film.

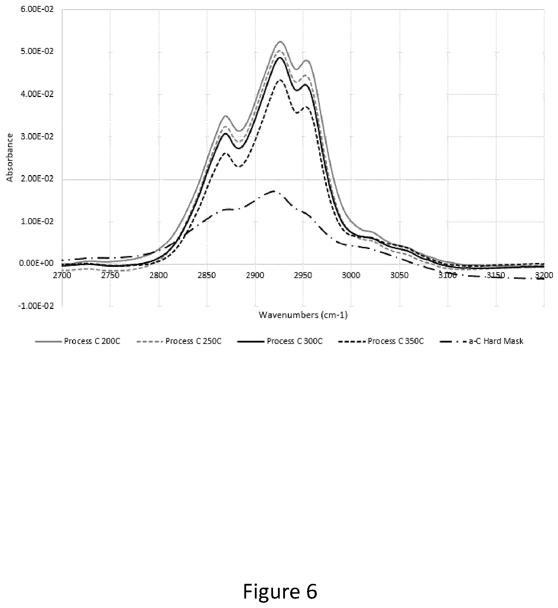

As explained above, temperature was found to be important for tuning the amorphous hydrogenated carbon films, with there being a relatively narrow range for optimal deposition of 250-350 degrees Celsius, outside of which the electrical properties degrade. As shown in Figure 6, for fixed process parameters based on process C, the sp3 C-Hx peaks reduce with increasing temperature. However, there is little change in the sp2 C-Hx peaks above 3000cm-1 beyond ~250 degrees Celsius. For reference also included is the equivalent spectra for the hard mask film deposited at the same temperature. There is a stronger absorption of a variety of C-Hx peaks when compared to the hard mask film.

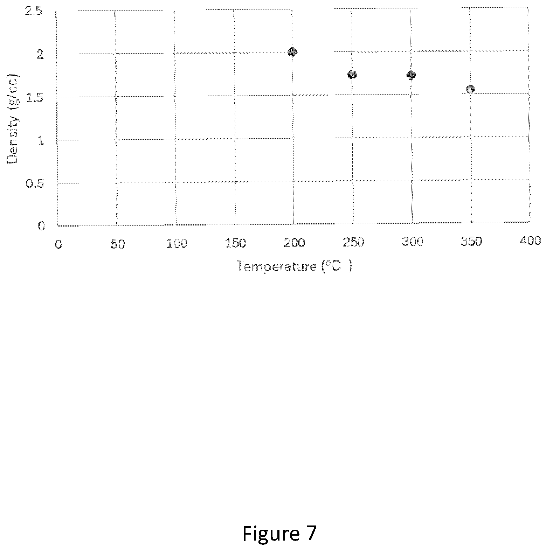

Film density was surprisingly found to reduce with increasing temperature. As shown in Figure 7, films deposited according to process C with a varying wafer support temperature had a density that reduced with increasing temperature.

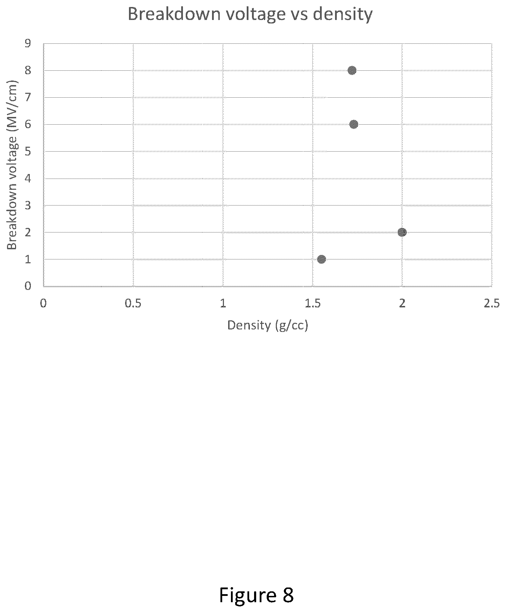

As shown in Figure 8, breakdown voltage was found to vary according to the film density. Optimal film electrical properties were associated with low density (1.6-1.8 g/cc) films deposited between 250-300 degrees Celsius.

Argon was required to achieve a high deposition rate as it is understood to help produce C₂H & H in the plasma and to provide Ar+ ion bombardment during film growth.

Thus, in embodiments of the invention, there is provided a low density amorphous hydrogenated carbon thin film deposited on a wafer, wherein the film exhibits good dielectric performance at acceptable yields.

## Claims

1. A method of plasma-enhanced chemical vapor deposition comprising the steps of:
supporting a wafer within a reactor chamber on a wafer support;
generating a plasma from acetylene, hydrogen and argon gases using a high frequency RF power supply; and
depositing an amorphous hydrogenated carbon film on the wafer;
wherein during the deposition the reactor chamber pressure is within the range 1-6 Torr; and
wherein during the deposition the wafer support temperature is between 200-350 degrees Celsius;
such that the deposited amorphous hydrogenated carbon film provides a dielectric layer on the wafer exhibiting low leakage currents of less than 1.0E-07 A/cm² at an operating voltage of 2 MV/cm and a high breakdown voltage of more than 6 MV/cm.

2. A method according to claim 1, wherein during the deposition the wafer support temperature is in the range 225-325 degrees Celsius, optionally wherein during the deposition the wafer support temperature is in the range 250-300 degrees Celsius.

3. A method according to any preceding claim, wherein the plasma is generated using a RF power supply at 13.56 MHz; and/or a RF power supply providing a power between 500-1500 W.

4. A method according to any preceding claim, wherein the plasma is generated using a RF driven showerhead and an electrically grounded wafer support.

5. A method according to any preceding claim, wherein the reactor chamber pressure is within the range 1.5-5 Torr.

6. A method according to any preceding claim, undertaken in a capacitively coupled reactor.

7. A method according to any preceding claim, wherein the acetylene gas is supplied to the reactor chamber at a flow rate in the range 100-600 sccm, optionally wherein the acetylene gas is supplied to the reactor chamber at a flow rate in the range 200-550 sccm.

8. A method according to any preceding claim, wherein the hydrogen gas is supplied to the reactor chamber at a flow rate in the range 100-600 sccm, optionally wherein the hydrogen gas is supplied to the reactor chamber at a flow rate in the range 250-550 sccm.

9. A method according to any preceding claim, wherein the argon gas is supplied to the reactor chamber at a flow rate in the range 200-1000 sccm, optionally wherein the argon gas is supplied to the reactor chamber at a flow rate in the range 300-900 sccm.

10. A method according to any preceding claim, wherein the wafer is a 300 mm silicon wafer.

11. A method according to any preceding claim, wherein the film deposited has a thickness between 150-1000 nm.

12. A method according to any preceding claim, wherein the deposited amorphous hydrogenated carbon film has a density of 1.6-1.8 g/cc.

13. A plasma-enhanced chemical vapor deposition system configured to undertake the method of any of claims 1-12, the system comprising:
a reactor chamber;
a gas inlet arranged to supply acetylene, hydrogen and argon gases to the reactor chamber;
a wafer support configured to support a wafer within the reactor chamber;
an RF power supply coupled to the reactor chamber.

14. A system according to claim 13, wherein the wafer support is grounded and arranged to be resistively heated to thereby heat the wafer.

15. A system according to claim 13 or 14, further comprising a cooling mechanism associated with the wafer support and configured to cool the wafer; and/or further comprising one or more flow control units configured to adjust the flow of the gases into and/or out of the reactor chamber.
